Europäisches Patentamt

European Patent Office

Office européen des brevets

(11) Publication number: **0 094 645**
**A2**

## (12) EUROPEAN PATENT APPLICATION

(21) Application number: **83104747.7**

(22) Date of filing: **13.05.83**

(51) Int. Cl.³: **G 06 F 11/20**

(30) Priority: **14.05.82 JP 79938/82**

(43) Date of publication of application:
**23.11.83 Bulletin 83/47**

(84) Designated Contracting States:
**DE FR GB IT**

(71) Applicant: **HITACHI, LTD.**
**6, Kanda Surugadai 4-chome Chiyoda-ku**
**Tokyo(JP)**

(72) Inventor: **Shimohigashi, Katsuhiro**
**3-124-10, Dainan**
**Musashimurayama-shi Tokyo(JP)**

(72) Inventor: **Kawajiri, Yoshiki**
**1-48-18, Akatsuki-cho**
**Hachioji-shi Tokyo(JP)**

(72) Inventor: **Horiguchi, Masashi**
**4-14-6, Nishi-koigakubo**
**Kokubunji-shi Tokyo(JP)**

(72) Inventor: **Miyazawa, Kazuyuki**
**1586-1, Josuihoncho**
**Kodaira-shi Tokyo(JP)**

(72) Inventor: **Ishihara, Masamichi**
**2196-603, Hirai Hinodemachi**
**Nishitama-gun Tokyo(JP)**

(74) Representative: **Strehl, Peter et al,**
**Strehl, Schübel-Hopf, Schulz Patentanwälte**
**Widenmayerstrasse 17 Postfach 22 03 45**
**D-8000 München 22(DE)**

(54) Fault-tolerant circuitry for semiconductor memory.

(57) A semiconductor memory with a spare row (11) or column added to a memory array, comprising a substitution circuit which, in the presence of an address input appointing a defective selecting line, drives a spare selecting ($WL_S$) line in place of regular selecting lines (WL). In order to disable all the regular selecting lines (WL), a drive pulse ($\phi_x$) to be impressed on drivers (WD) for these selecting lines (WL) is cut off.

FIG. 3

Croydon Printing Company Ltd.

EPA-26 113

Title of the Invention

FAULT-TOLERANT CIRCUITRY FOR SEMICONDUCTOR MEMORY

Background of the Invention

The present invention relates to a semiconductor memory employing a redundancy technique, and more particularly to a substitution circuit for switching and driving defective selecting lines and spare selecting lines.

Various on-chip redundancy techniques for semiconductor memories have been proposed. Usually, the memory employing such redundancy technique has spare rows or columns in a memory array, and it includes a substitution circuit which consists of a spare decoder composed of programmable elements for driving select lines for the spare rows or columns (hereinbelow, called "spare lines"), and disabling circuitry for disabling select lines for regular rows or columns (word lines or data lines) by the use of an output from the spare decoder. When a fault has been found in the regular row or column, the spare decoder is programmed to the address of the particular row or column, so as to select the spare line instead of the select line for the row or column including the fault (hereinbelow, called "faulty line").

Problems in such semiconductor memory employing the redundancy technique are the enlargement of the chip size ascribable to the addition of the redundant portion as well as the substitution circuit, and the increase of the access time ascribable to the signal delay of the substitution circuit.

In an example introduced in 'ISSCC DIGEST OF TECHNICAL PAPERS', pp. 80 - 81, the input end of each regular decoder for selecting a corresponding regular row or column is increased by one bit in order to form a substitution circuit, and a disabling signal outputted from a spare decoder is applied to the additional bit of the input end of the regular decoder. With this circuit arrangement, the numbers of elements of all the regular decoders increase to incur the increase of the pitch of a memory array. Moreover, a great signal delay is involved until the disabling signal is transmitted to all the regular decoders.

Summary of the Invention

An object of the present invention is to provide fault-tolerant circuitry for a semiconductor memory in which the number of elements increases little when forming a substitution circuit for spare lines and defective selecting lines, so that the chip size does not enlarge.

Another object of the present invention is to provide fault-tolerant circuitry for a semiconductor memory which avoids the transmission delay of a disabling signal for disabling the selection of defective selecting lines, thereby to make high-speed access possible.

- 3 -

0094645

The present invention is characterized in that a drive pulse which is impressed on drivers in order to start the drivers for driving regular select lines is cut off by the output of a spare decoder, thereby to disable the regular select lines.

## Brief Description of the Drawings

Figure 1 is a circuit diagram showing an example of prior-art fault-tolerant circuitry for a semiconductor memory;

Figure 2 is a circuit diagram of a block XD in Figure 1;

Figure 3 is a circuit diagram showing an embodiment of the present invention;

Figure 4 is a circuit diagram of a block PXD in Figure 3; and

Figure 5 is a circuit diagram of a block XD in Figure 3.

## Detailed Description

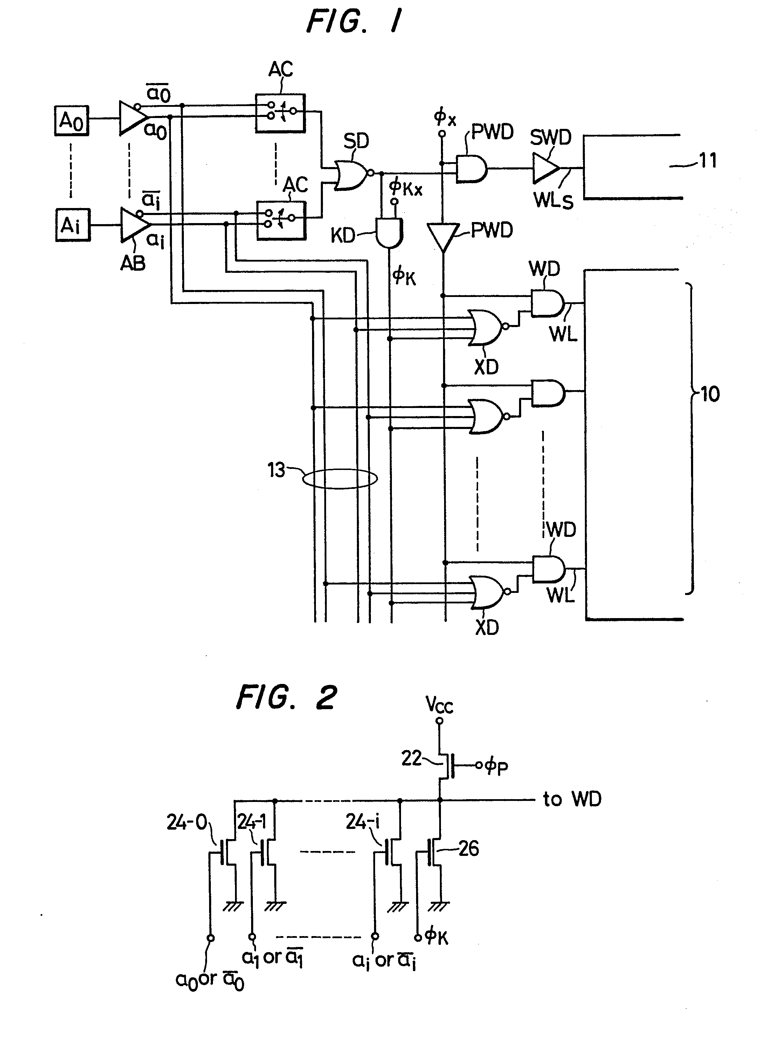

Before the description of an embodiment of the present invention, an example of prior-art fault-tolerant circuitry will be explained with reference to Figures 1 and 2.

A spare row 11 is arranged in adjacency to the regular rows 10 of a memory array. Word lines WL and a spare word line $WL_S$ are respectively driven by word drivers WD and a spare word driver SWD. External address signals $A_0$, $\cdots$ and $A_i$ are fed into address buffers AB. The address buffers AB generate internal address signals which consist of true signals $a_0$, $\cdots$ and $a_i$ inphase with the received address signals and complemental signals $\overline{a_0}$, $\cdots$ and $\overline{a_i}$ antiphase thereto. The internal address signals are transmitted through internal address signal lines 13 to decoders XD for selecting the regular rows. In addition, they are applied to a spare decoder SD through address comparator circuits AC which are constructed of programmable elements.

When the input address to the address buffer AB has agreed with the stored content of the address comparator circuit AC, the output of the spare decoder SD becomes a high potential, and the spare row is selected instead of the faulty row. More specifically, upon rise of a control signal $\phi_{kx}$, a disabling signal $\phi_k$ of high potential is provided from an AND circuit KD. This signal $\phi_k$ is inputted to the regular word decoders XD, and turns "off" all these decoders XD to render all the regular word lines WL unselected. On the other hand, the output of the spare decoder SD enters a spare pre-word driver PWD. Subject to its AND with a word drive pulse $\phi_x$, it is passed through the spare word driver SWD to drive the spare word line $WL_S$. As shown in Figure 2, the word decoder XD is composed of a MOS transistor 22 on which a precharge control pulse $\phi_p$ is impressed, MOS transistors 24-0, ····· and 24-i to which the internal address signals are respectively applied, and a MOS transistor 26 to which the disabling signal $\phi_k$ is applied. The MOS transistor 26 has been added for the substitution of the faulty word line with the spare word line, and the number of transistors in the whole memory increases by the number of the word decoders XD (256 in case of a 64 kbit-memory). Moreover, such enlargement of the word decoder incurs the extension of the wiring pitch of the word lines WL, which leads to the enlargement of the chip size.

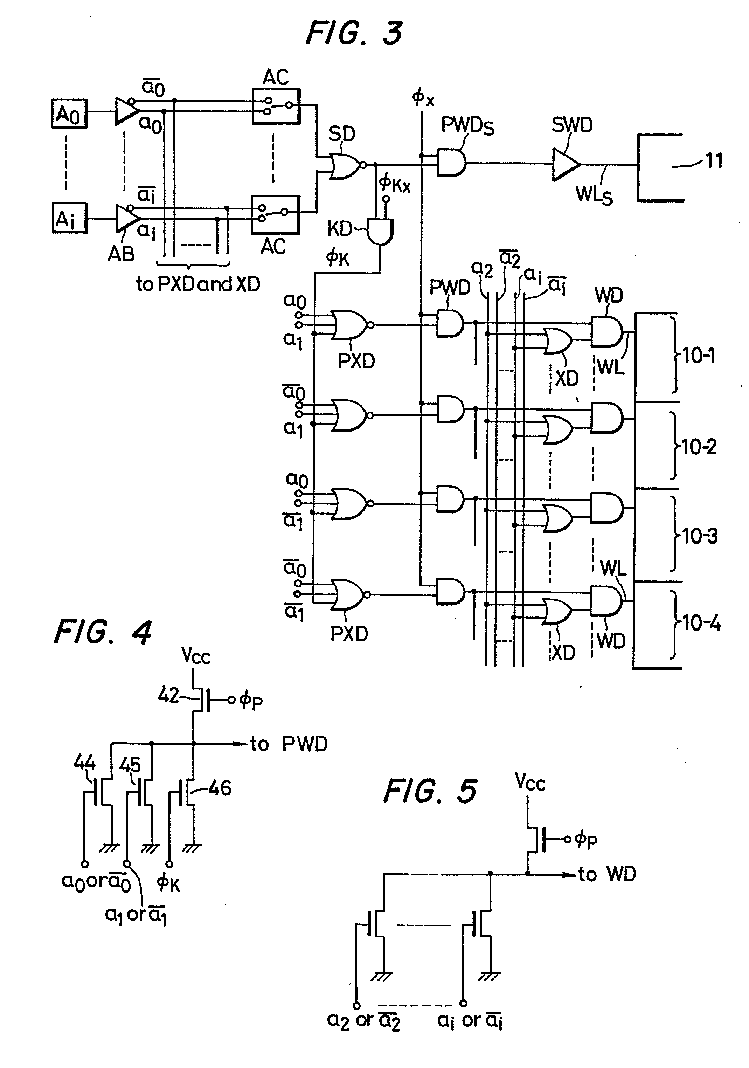

Figure 3 shows an embodiment of the present invention.

A memory array consists of four subarrays 10-1, 10-2, 10-3 and 10-4, and has a spare row 11 added thereto. A spare word line $WL_S$ which is a select line for the spare rows is driven by a spare word driver SWD. While a plurality of word lines WL are laid for each subarray, only one for each is illustrated in the figure with the others omitted. The word lines WL are driven by word drivers WD.

External address inputs $A_0 - A_i$ are converted into voltage levels within a chip and thus put into internal address signals by address buffers AB. The internal address signals consist of true signals $a_0$, $\cdots\cdots$ and $a_i$ inphase with the input signals and complemental signals $\overline{a_0}$, $\cdots\cdots$ and $\overline{a_i}$ in complemental relationship thereto. The two pairing signals are applied to an address comparator circuit AC which is disposed for each address buffer. The address comparator circuit includes an on-chip ROM, which is programed thereby to connect a switch S at an output end to either the true or complemental signal.

The outputs of the address comparators AC are inputted to a spare decoder SD. The spare word decoder SD is an ordinary NOR circuit. By way of example, in a case where the word line having an address whose address bits are all "0" is substituted by the spare word line $WL_S$, all the switches S of the comparators AC are programed in the "true" direction. Hereinbelow, voltage relations will be indicated as to a case of employing n-channel MOS transistors as constituent elements. In this case, when all the external address inputs $A_0 - A_i$ are 0 V (logic "0"), they coincide with the contents of the comparators AC, and the true signals $a_0 - a_i$ enter the spare decoder SD. Since all these signal voltages are 0 V, the output of the NOR circuit SD becomes a high voltage (SD selecting status). In actuality, one more enable signal (not shown) enters the spare decoder SD as an input. The role of this enable signal is to decide whether or not a fault is saved. The output of the spare decoder directly enters a spare pre-word driver $PWD_S$, and upon entry of a word line drive pulse $\phi_x$, the spare word line $WL_S$ becomes a high voltage to establish a selected status. On the other hand, when the spare word line $WL_S$ is selected, all the regular word lines WL become unselected. More specifically, when the output of the spare decoder SD becomes the high potential, a disabling signal $\phi_k$ is provided from an AND circuit KD upon rise of a control pulse $\phi_{kx}$, and it is applied to four pre-word decoders PXD. As shown in Figure 4, the pre-word decoder PXD has the arrangement of a NOR circuit consisting of a MOS transistor 42 on which a precharge control pulse $\phi_p$ is impressed, MOS transistors 44 and 45 to which the first and second bits of the internal address signals ($a_0$ or $\overline{a_0}$, and $a_1$ or $\overline{a_1}$) are respectively applied, and a MOS transistor 46 to which a disabling signal $\phi_k$ is applied. Accordingly, when the disabling signal $\phi_k$ becomes a high potential, none of the regular word drivers WD is driven in spite of the rise of the word line drive pulse $\phi_x$, and all the regular word lines WL become unselected.

In a case where the input address does not coincide with the address programed in the address comparator circuits AC, the disabling signal $\phi_k$ does not become the high potential, and one of the regular word lines WL is driven. More specifically, one of the four pre-word decoders PXD is selected by the first and second bits of the internal address signals, and the output of one of the pre-word drivers PWD rises simultaneously with the rise of the word line drive pulse $\phi_x$. On the other hand, one of the decoders XD of the respective subarrays has been selected by the remaining bits of the internal address signals. Thus, one of all the word drivers WD drives the corresponding word line WL in response to the signal $\phi_x$. Figure 5 shows the circuit arrangement of the decoder XD in Figure 3.

In the embodiment stated above, the transistors 46 are added to the pre-word decoders PXD in order to substitute the spare word line for the faulty word line, and they number 4 (four). Since the word decoder XD includes no element to be added for the substitution between the faulty word line and the spare word line, the occupying area of this portion does not increase. Moreover, the wiring pitch of the word lines WL does not increase, which is advantageous for rendering the memory array smaller.

In addition, since the change-over between the spare word line and the faulty word line is effected in the portion of an indirect peripheral circuit, the substitution circuit may be arranged on any part of the chip, so that the circuitry of the invention is rich in flexibility. Besides, the length of wiring for the disabling signal $\phi_k$ can be reduced, so that an enhanced operating speed becomes possible.

While the above embodiment has referred to the memory which has the spare row and which is provided with the spare word line to be substituted for the word line, the present invention is similarly applicable to a memory which has a spare column and which is provided with a spare data line to be substituted for a data line. Of course, the invention is applicable to a case where a plurality of such spare lines are provided.

What we claim is:

In a semiconductor memory having a spare word line $(11, WL_S)$ or data line; a semiconductor memory comprising fault-tolerant circuitry in which, when said spare word line $(11, WL_S)$ or data line is selected, regular word lines or data lines $(10, WL)$ are rendered unselected by cutting off a word line drive pulse or data line select pulse $(\phi_x)$ for driving said regular word lines or data lines $(10, WL)$.

FIG. 1

FIG. 2

# FIG. 3

# FIG. 4

# FIG. 5